# EUROPEAN PATENT APPLICATION

(11) **EP 4 826 400 A1**
(43) Date of publication of application: **21.10.2026**
(21) Application number: 26172473.6
(22) Date of filing: 15.04.2026
(51) Int. Cl.: G01R 31/317, G01R 31/30, G01R 31/3173

(54) **METHOD AND APPARATUS FOR SELECTIVE AND ADAPTIVE MARGIN TEST**

(30) Priority: 17.04.2025 US 202519182400
(71) Applicant: Synaptics Incorporated, San Jose, CA 95131 (US)
(72) Inventor: GUPTA, Navneet, San Jose, 95131 (US)
(74) Representative: J A Kemp LLP

(57) **Abstract**

Adaptive check and control logic and processes are used for monitoring performance of an integrated circuit by directly determining at least one of setup margins, hold margins, and voltage margins in one or more critical paths of the integrated circuit. The data state of the start and end points of the critical path are preserved prior to an adaptive test and the functional clock for the integrated circuit is gated. The adaptive test is performed by loading test data into the start point of the critical path and using an adaptive test clock to capture the test data at the end point of the critical path. The captured data is compared to expected values to detect timing violations. When the adaptive test is completed, the data state of the start and end points of the critical path are reloaded and the function clock for the integrated circuit is enabled.

## Description

### TECHNICAL FIELD

The present implementations relate generally to monitoring the performance of integrated circuits, and specifically to devices and techniques for monitoring speed and power consumption in integrated circuits.

### BACKGROUND OF RELATED ART

Power consumption is one of the key factors in the performance of integrated circuits. Integrated circuits are driven by a supply voltage and a clock frequency. The power consumption in an integrated circuit may be significantly lowered by decreasing the supply voltage and/or the clock frequency. Reducing the power consumption of an integrated circuit may be particularly desirable in integrated circuits used in mobile devices, such as smart phones, tables, laptops, etc., where battery life is an important factor. Reducing the supply voltage and/or the clock frequency, however, may reduce the speed at which the integrated circuit operates. For proper functionality, critical operations in the integrated circuit need to be able to be performed sufficiently fast.

With increasing performance demands, power consumption is becoming a bottleneck in many systems due to various reasons such as peak power consumption, power-density/hot-spot/thermal issues, and battery lifetime. This problem is even more pronounced in battery operated systems, where there is a continuous need to extend retention time.

Reducing voltage provides significant saving in both leakage and active power. However, gains obtained by reducing voltage are limited due to the timing margins needed to account for fabrication process variation and to maintain yield. Due to such requirements, ASIC (Application Specific Integrated Circuits) designs may sometimes include complex power management mechanisms in which the supply voltage and/or the clock frequency may be adjusted, e.g., to the prevailing speed of the integrated circuit. Example of power saving mechanisms include Dynamic-Voltage-Frequency-Scaling (DVFS), and adaptive-voltage scaling (AVS).

In order to adjust the supply voltage and/or the clock frequency, a performance monitor is sometimes used. Conventional performance monitors, for example, may include a delay line that replicates a critical path in the integrated circuit, and are used to provide a measurement of speed of the integrated circuit. Conventional performance monitors, however, do not analyze all relevant timing margins and generally operate by merely predicting or estimating the performance of the integrated circuit or monitor performance independently of the critical path, and accordingly, are reaching their limits in the utility of power management. Accordingly, improvements in the performance monitoring mechanisms are desirable.

### SUMMARY

This Summary is provided to introduce in a simplified form a selection of concepts that are further described below in the Detailed Description. This Summary is not intended to identify key features or essential features of the claimed subject matter, nor is it intended to limit the scope of the claimed subject matter.

One innovative aspect of the subject matter of this disclosure can be implemented in an apparatus for monitoring performance of an integrated circuit. The apparatus includes a first adaptive check logic circuit that includes a first state preserving electrical component comprising one of a multiplexer or latch that is coupled to a start point of a critical path in the integrated circuit. The first adaptive check logic circuit that includes the first state preserving electrical component preserves a first data state of the start point of the critical path from before an adaptive test, provides an adaptive check data pattern to the start point of the critical path during the adaptive test, and reloads the first data state to the start point of the critical path after the adaptive test. The apparatus further includes a second adaptive check logic circuit that includes a second state preserving electrical component comprising one of a multiplexer or latch that is coupled to an end point of the critical path in the integrated circuit. The second adaptive check logic circuit that includes the second state preserving electrical component preserves a second data state of the end point of the critical path from before the adaptive test, provides a timing violation signal indicative of a setup violation or a hold violation in response to an adaptive check data pattern during the adaptive test, and reloads the second data state to the end point of the critical path after the adaptive test. The apparatus further includes an integrated clock gating cell coupled to the critical path. The integrated clock gating cell selectively enables a functional clock signal to the critical path and disables an adaptive test clock signal to the critical path before and after the adaptive test and selectively disables the functional clock signal to the critical path and enables the adaptive test clock signal to the critical path during the adaptive test.

One innovative aspect of the subject matter of this disclosure can be implemented in a method for monitoring performance of an integrated circuit. The method includes preserving a first data state of a start point of a critical path and a second data state of an end point of the critical path from before an adaptive test, and disabling a functional clock signal to the critical path and enabling an adaptive test clock signal to the critical path during the adaptive test. The method further includes providing an adaptive check data pattern to the start point of the critical path during the adaptive test and generating a timing violation signal indicative of a setup violation or a hold violation at the end point of the critical path in response to the adaptive check data pattern during the adaptive test. The method further includes restoring the first data state to the start point of the critical path and the second data state of the end point of the critical path after the adaptive test, and disabling the adaptive test clock signal to the critical path and enabling the functional clock signal to the critical path after the adaptive test.

One innovative aspect of the subject matter of this disclosure can be implemented in a controller for monitoring performance of an integrated circuit. The controller includes a processing system and an adaptive check and control logic comprising a first adaptive check logic circuit and a second adaptive check logic circuit that are coupled to the processing system, wherein processing system is configured to perform operations. The controller may be caused to send an adaptive test enable signal to the first adaptive check logic circuit that includes at least one of a multiplexer or latch coupled to a start point of a critical path in the integrated circuit to preserve a first data state of the start point of the critical path and to the second adaptive check logic circuit that includes at least one of a multiplexer or latch coupled to an end point of the critical path in the integrated circuit to preserve a second data state of the end point of the critical path from before an adaptive test. The controller may be further caused to send an adaptive check clock signal to disable a functional clock signal to the critical path and enable an adaptive test clock signal to the critical path during the adaptive test. The controller may be further caused to send an adaptive check data signal to provide an adaptive check pattern to the start point of the critical path during the adaptive test and to send a timing event capture signal to capture a timing violation signal indicative of a setup violation or a hold violation at the end point of the critical path in response to the adaptive check pattern during the adaptive test. The controller may be further caused to send an adaptive check reload signal to the first adaptive check logic circuit to reload the first data state to the start point of the critical path after the adaptive test and to the second adaptive check logic circuit to reload the second data signal state to the end point of the critical path after the adaptive test, and send the adaptive check clock signal to enable the functional clock signal to the critical path after the adaptive test.

### BRIEF DESCRIPTION OF THE DRAWINGS

The present implementations are illustrated by way of example and are not intended to be limited by the figures of the accompanying drawings.
FIG. 1 shows a simplified view of a pipeline architecture of a digital circuit that may be included in an integrated circuit.
FIG. 2 illustrates an example pipeline architecture of the critical path in the digital circuit shown in FIG. 1.
FIG. 3 shows a pipeline architecture of a digital circuit that includes adaptive check and control logic for performance monitoring of the critical path.
FIG. 4 illustrates an example pipeline architecture for the critical path with adaptive check and control logic.
FIG. 5 illustrates an example pipeline architecture for the critical path with adaptive check and control logic with a data delay chain and clock delay chain in the critical path.
FIGs. 6 and 7 show waveforms illustrating a setup margin check using the adaptive check and control logic as referred to in FIGs. 3-5, with no timing violation and with a detected timing violation, respectively.
FIGs. 8 and 9 show waveforms illustrating a hold margin check using the adaptive check and control logic as referred to in FIGs. 3-5, with no timing violation and with a detected timing violation, respectively.
FIG. 10 is a flow chart illustrating an example of controlling the adaptive testing process using the adaptive check and control logic discussed herein.
FIG. 11 shows a block diagram of an example controller that may be used with the adaptive check and control logic to perform margin testing as discussed herein.
FIG. 12 shows an illustrative flowchart depicting an example method for monitoring performance of an integrated circuit, according to some implementations.

### DETAILED DESCRIPTION

In the following description, numerous specific details are set forth such as examples of specific components, circuits, and processes to provide a thorough understanding of the present disclosure. The term "coupled" as used herein means connected directly to or connected through one or more intervening components or circuits. The terms "electronic system" and "electronic device" may be used interchangeably to refer to any system capable of electronically processing information. Also, in the following description and for purposes of explanation, specific nomenclature is set forth to provide a thorough understanding of the aspects of the disclosure. However, it will be apparent to one skilled in the art that these specific details may not be required to practice the example implementations. In other instances, well-known circuits and devices are shown in block diagram form to avoid obscuring the present disclosure. Some portions of the detailed descriptions which follow are presented in terms of procedures, logic blocks, processing and other symbolic representations of operations on data bits within a computer memory.

These descriptions and representations are the means used by those skilled in the data processing arts to most effectively convey the substance of their work to others skilled in the art. In the present disclosure, a procedure, logic block, process, or the like, is conceived to be a self-consistent sequence of steps or instructions leading to a desired result. The steps are those requiring physical manipulations of physical quantities. Usually, although not necessarily, these quantities take the form of electrical or magnetic signals capable of being stored, transferred, combined, compared, and otherwise manipulated in a computer system. It should be borne in mind, however, that all of these and similar terms are to be associated with the appropriate physical quantities and are merely convenient labels applied to these quantities.

Unless specifically stated otherwise as apparent from the following discussions, it is appreciated that throughout the present application, discussions utilizing the terms such as "accessing," "receiving," "sending," "using," "selecting," "determining," "normalizing," "multiplying," "averaging," "monitoring," "comparing," "applying," "updating," "measuring," "deriving" or the like, refer to the actions and processes of a computer system, or similar electronic computing device, that manipulates and transforms data represented as physical (electronic) quantities within the computer system's registers and memories into other data similarly represented as physical quantities within the computer system memories or registers or other such information storage, transmission or display devices.

In the figures, a single block may be described as performing a function or functions; however, in actual practice, the function or functions performed by that block may be performed in a single component or across multiple components, and/or may be performed using hardware, using software, or using a combination of hardware and software. To clearly illustrate this interchangeability of hardware and software, various illustrative components, blocks, modules, circuits, and steps have been described below generally in terms of their functionality. Whether such functionality is implemented as hardware or software depends upon the particular application and design constraints imposed on the overall system. Skilled artisans may implement the described functionality in varying ways for each particular application, but such implementation decisions should not be interpreted as causing a departure from the scope of the present disclosure. Also, the example input devices may include components other than those shown, including well-known components such as a processor, memory and the like.

The techniques described herein may be implemented in hardware, software, firmware (e.g., software that is embedded directly in hardware), or any combination thereof, unless specifically described as being implemented in a specific manner. Any features described as modules or components may also be implemented together in an integrated logic device or separately as discrete but interoperable logic devices. If implemented in software, the techniques may be realized at least in part by a non-transitory processor-readable storage medium including instructions that, when executed, performs one or more of the methods described above. The non-transitory processor-readable data storage medium may form part of a computer program product, which may include packaging materials.

The non-transitory processor-readable storage medium may comprise random access memory (RAM) such as synchronous dynamic random-access memory (SDRAM), read only memory (ROM), non-volatile random access memory (NVRAM), electrically erasable programmable read-only memory (EEPROM), FLASH memory, other known storage media, and the like. The techniques additionally, or alternatively, may be realized at least in part by a processor-readable communication medium that carries or communicates code in the form of instructions or data structures and that can be accessed, read, and/or executed by a computer or other processor.

The various illustrative logical blocks, modules, circuits and instructions described in connection with the implementations disclosed herein may be executed by one or more processors (or a processing system). The term "processor," as used herein may refer to any general-purpose processor, special-purpose processor, conventional processor, controller, microcontroller, and/or state machine capable of executing scripts or instructions of one or more software programs stored in memory.

As discussed herein, performance monitoring mechanisms and techniques for an integrated circuit enable in design measurement of setup margins, hold margins, and voltage margins for efficient power management, e.g., using adaptive voltage scaling (AVS) or similar mechanisms. The in-design performance monitoring mechanisms and techniques discussed herein ensure that no errors are generated in the application data or propagated in the designed circuit, thereby avoiding complex architectural changes that otherwise would be required for error correction. Additionally, the performance monitoring mechanisms and techniques improves area optimization and/or power optimization, while limiting the necessary overhead. Silicon implementation and testing cost is also optimized using the performance monitoring mechanisms and techniques discussed herein.

The performance monitoring mechanisms and techniques discussed herein enable measurement of setup margins, hold margins, and voltage margins in the design of the integrated circuit. Setup and hold margins are critical timing parameters that are used to ensure reliable operation of circuits, such as where data is transferred between flip-flops or registers based on a clock signal. The setup and hold margins are related to the timing requirements relative to a clock edge.

The setup margin, for example, refers to the amount of extra time, e.g., beyond a minimum requirement, that is available for the data signal to stabilize at the input of a flip-flop or register before the clock edge triggers the capture of the data signal. The setup margin ensures that the flip-flop captures the correct data by avoiding transitions that are too close to the clock edge. Reducing the setup margin is desirable to reduce power requirements, however, setup violation must be avoided as the data will arrive too late to be captured.

The hold margin is another critical timing parameter that refers to the amount of extra time, e.g., beyond the minimum requirement, that the data signal remains stable at the input of a flip-flop or register after the clock edge. The hold margin ensures that the flip-flop captures to the correct data by preventing a change in the data too soon after the clock edge. Reducing the hold margin is desirable to reduce power requirements, however, a hold violation must be avoided as the data may change too soon resulting in the capture of corrupted data.

The voltage margin is not strictly a timing parameter but is related to the electrical operating conditions of the integrated circuit, and is focused on the robustness of the circuit's operation across a range of supply voltages. The voltage margin, for example, refers to a difference between the actual supply voltage applied to the circuit and the minimum or maximum voltage required for the circuit to operate correctly under specified conditions, such as the current speed, temperature, power supply noise, aging, manufacturing variations, etc. The voltage margin, thus, is a measure of how much voltage difference can be tolerated before the circuit fails due to insufficient or excessive voltage. The voltage margin, as discussed herein, may be a timing margin, e.g., setup and/or hold, that is determined in terms of voltage. Similar to reducing the timing parameters, reducing the voltage margin is desirable to reduce power requirements, however, a negative voltage margin may result in improper operation of the circuit.

As discussed herein, various margins, e.g., setup and/or hold margins, may be determined in units of time, voltage, buffer count or clock steps.

The performance monitoring mechanisms and techniques discussed herein advantageously works with standard electronic design automation (EDA) tools and implementation flow enabling scalability and, therefore, reducing implementation cost.

Additionally, the performance monitoring mechanisms and techniques may be used for area-only optimizations, i.e., not used for power optimization, while maintaining performance. Area-only optimization, for example, may be performed during the implementation phase by allowing signoff timing of slow corners on higher voltage, and the post fabrication voltage required for an individual chip may be determined using an implementation of the performance monitoring mechanisms and techniques discussed herein.

In contrast to the performance monitoring mechanisms and techniques discussed herein, conventional performance monitoring systems focus on reducing only setup margin as it limits the frequency of operation, therefore, voltage for a given frequency of the design. Some conventional systems, for example, may perform setup violation detection and error correction to support voltage scaling using modifications in the design architecture to handle errors. Such systems, for example, may use either special flip-flops which can detect timing violations, or may use extra detectors. The required architecture change to implement error correction in runtime in such systems is problematic. For example, the required architecture change increases risk in silicon proven designs. Additionally, a significant area of extra logic may need to be added due to the fact that a significant number of critical paths need to be covered for robustness. Further, these systems face additional challenges in timing while implementing error-correction in high-speed designs due to feedback loops for error-correction. Additionally, these systems fail to provide a solution for hold margin removal, and hold margin increases with a reduction in supply voltage.

Another conventional technique may attempt to prevent setup violation using predicted margins. Such a system, for example, may use replicas of critical paths or may add extra detector flip-flops, and other kind of detectors. An early warning on the detector may be created either by adding delay in the data or by adding delay in the clock. The use of such techniques, however, is problematic because margin detectors require a significant area, e.g., adding buffers and flip-flops or latches. Consequently, these systems have a significant cost in area and expenses of the ASIC. Additionally, these systems fail to provide a solution for hold margin removal, and hold margin increases with a reduction in supply voltage.

Another conventional system may use self-correcting techniques that do not require functional design changes. Such systems are similar to those described above, but, in addition, they implement self-correction to avoid major architecture changes. Similar to the above, these techniques also use extra detector buffers and flip-flops which have an attendant cost in area. Further, these techniques require extra logic that is needed for self-correction. Additionally, these systems fail to provide a solution for hold margin removal, and hold margin increases with a reduction in supply voltage.

Another conventional technique may use passive reduction of margin using process, voltage and temperature sensors. Such a system, for example, may use sensors in the chip to predict the variations, which can be independent of actual design logic. Such systems, however, cannot remove local intra-die variation efficiently, and accordingly, are limited in gain. Further, a large number of sensors is required to reduce margin efficiently, which leads to increased area, power and cost of the ASIC. Additionally, these systems fail to provide a solution for hold margin removal, and hold margin increases with a reduction in supply voltage.

Alternatively, the implementation of the design may be optimized, e.g., using advance implementation and testing techniques to reduce margin required as much as possible. This may be done, for example, with optimization of standard cells, floor-plan, clock-tree and careful selection of operating voltages and signoff corners. Such a technique, however, has limited power saving. For example, with aggressive voltage scaling, the gains diminish due to increased variation on near-threshold voltages.

As described herein, adaptive check and control logic and processes are used for monitoring performance of an integrated circuit by directly determining at least one of setup margins, hold margins, and voltage margins in one or more critical paths of the integrated circuit. Adaptive check logic circuits, which include at least one multiplexer, are connected to the start point and the end point of the critical path. The adaptive check logic circuits are used to preserve the data state of the start point and end point of the critical path prior to performing an adaptive test, and to reload the preserved data state to the start point and end point of the critical path after the adaptive test. The adaptive check logic circuit connected to the start point of the critical path additionally provides an adaptive check data pattern to the start point of the critical path during the adaptive test, while the adaptive check logic circuit connected to the end point of the critical path provides a timing violation signal indicative of a setup violation or a hold violation in response to adaptive check data pattern during the adaptive test. Additionally, an integrated clock gating cell that is connected to the critical path is used to selectively enable a functional clock signal to the critical path and disable an adaptive test clock signal to the critical path before and after the adaptive test and to selectively disable the functional clock signal to the critical path and enable the adaptive test clock signal to the critical path during the adaptive test.

The adaptive check and control logic, as discussed herein, detects margin parameters in-situ and checks the actual critical paths. Additionally, the adaptive check and control logic enables not only setup-violation detection but enables hold-violation detection and voltage-margin determination for hold. The adaptive check and control logic may be used to aggressively reduce margins, e.g., limited by selected delay or voltage step sizes used during testing, for both setup and hold while limiting any additional logic that is required for adaptive scaling. As the hold fixing on lower voltage is not pessimistic, the techniques discussed herein provide better area and power due to fact that it is not limited by cost of hold fixing while reducing voltage aggressively. The adaptive check and control logic further enables coverage of more critical paths in the design that conventional systems without significantly increasing area requires for logic. Covering more critical paths in the design, allows for a more aggressive reduction in voltage margins, therefore, allowing more efficient adaptive scaling, e.g., using AVS and/or DVFS. Further, the proposed adaptive check and control logic and technique is scalable for high-speed designs without limitation because the clock can be controlled independently during data preservation and reload phases.

Accordingly, the adaptive check and control logic and techniques discussed herein are beneficial as it allows performance monitoring with a reduced area on the chip and is a cost-effective way to support aggressive voltage scaling without significantly impacting area; therefore, power and energy optimization. Further, thermal issues for on-chip power management components are reduced, and energy efficiency and battery lifetime are improved.

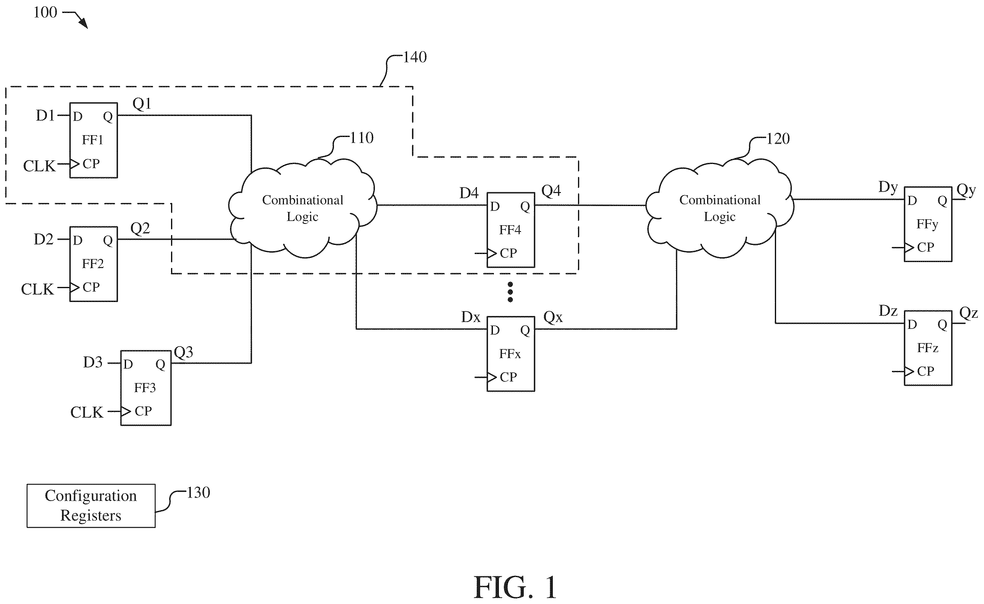

FIG. 1 shows a simplified view of a pipeline architecture of a digital circuit 100 that may be included in an integrated circuit. It should be understood that the digital circuit 100 is merely one example of a digital circuit and an integrated circuit may include other digital circuits and various combinations of digital circuits.

As illustrated, the digital circuit 100 includes various paths that start and end on flip-flops with combinational location disposed in between. For example, the start of the digital circuit is illustrated with flip-flop FF1, which receives data D1 at data pin D, a clock signal CLK at clock pin CP, and output data Q1 on output data pin Q. Additional flip-flops FF2 and FF3 are likewise illustrated as the front end of the digital circuit. The output data Q1, Q2, and Q3 from flip-flops FF1, FF2, and FF3, respective, are provided as fan-in inputs to combinational logic 110, which may include some functional logic, and provides data D4 to flip-flop FF4 and data Dx to flip-flop FFx. The output data Q4 and Qx from flip-flops FF4 and FFx, respective, are provided to combinational logic 120, which may include some functional logic, and provides data to the back end of the digital circuit as data Dy to flip-flop FFy and data Dz to flip-flop FFz. Control settings for the digital circuit may be provided by configuration registers 130.

An integrated circuit may include many different paths through which data signals may propagate. The digital circuit 100, for example, illustrates multiple paths for data to travel from the front end of the circuit including flip-flops FF1, FF2, and FF3 to the back end of the circuit including flip-flops FFy and FFz. The digital circuit 100 may include a critical path, which in general, refers to a path through the digital circuit that takes the longest time for a signal to propagate due to the cumulative delays of logic gates, flip-flops, or other components and defines the maximum clock frequency for the circuit. A critical path may include various delay components, including gate delays, e.g., time required by logic gates perform their functions, interconnect delays, e.g., time required for signals to travel through wires or routing between components, and setup and hold times, e.g., constraints imposed by memory elements, such as flip-flops, that require stable inputs for a certain time duration before and after a clock edge. As discussed above, an integrated circuit may include multiple digital circuits, each of which may have a different critical path. For example, a critical path 140 in the digital circuit 100 is illustrated as the path from flip-flop FF1 through combinational logic 110 to flip-flop FF4.

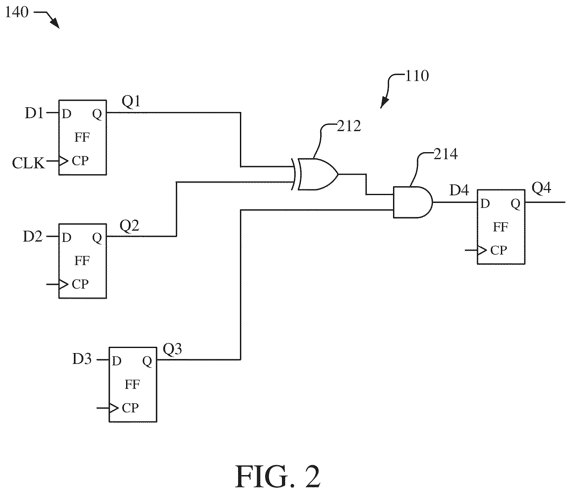

FIG. 2 illustrates an example pipeline architecture of the critical path 140 in the digital circuit 100 shown in FIG. 1. The critical path 140 is the path from the input of the flip-flop FF1 through combinational logic 110, illustrated as including exclusive or (XOR) gate 212 and AND gate 214, to the output of the flip-flop FF4. The flip-flops FF2 and FF3 provide fan-in inputs from non-critical paths to the combinational logic 110.

The performance of the critical path 140 may be monitored using adaptive check and control logic, as discussed herein. The adaptive check and control logic monitors the critical path itself, and enables measurement of setup margins, hold margins, and voltage margins without corrupting the actual data in the design.

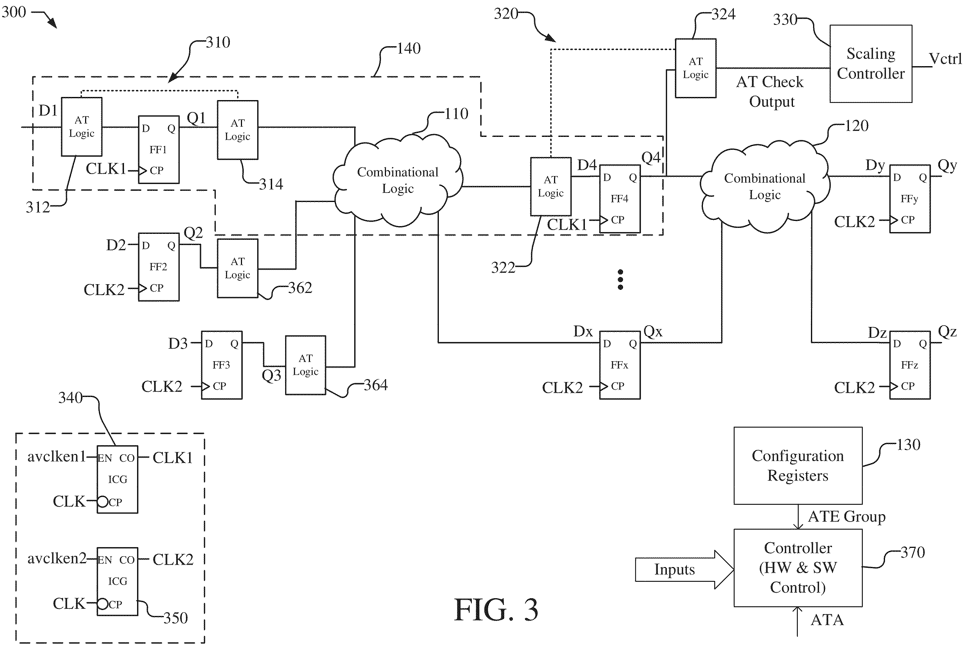

FIG. 3 shows a pipeline architecture of a digital circuit 300 that includes adaptive check and control logic for performance monitoring of a critical path. As illustrated, the pipeline architecture of a digital circuit 300 is similar to digital circuit 100 shown in FIG. 1, like designated elements being the same, with a critical path 140 from the input of the flip-flop FF1 through combinational logic 110 to the output of the flip-flop FF4. It should be understood that the illustrated critical path is merely shown for illustration of the components and function of the adaptive check and control logic used for performance monitoring of the critical path, and that actual critical paths may have more complex combinational logic on the paths.

The adaptive check and control logic for critical path 140 includes an adaptive check logic circuit 310, which includes at least one multiplexer, that is electrically connected to the start point of the critical path 140. The start point of the critical path, for example, is the beginning of the critical path where data is launched, e.g., the data pin D of flip-flop FF1, at a particular edge or level of a control signal, such as clock in synchronous circuits, such as received at the clock pin CP of flip-flop FF1. The at least one multiplexer in the adaptive check logic circuit 310 is used to preserve the data state of the start point of the critical path, e.g., at the data pin D of flip-flop FF1, from before the adaptive test is performed. Additionally, the at least one multiplexer in the adaptive check logic circuit 310 is used to provide an adaptive check data pattern to the start point of the critical path, e.g., at the data pin D of flip-flop FF1, during the adaptive test. Further, the at least one multiplexer in the adaptive check logic circuit 310 is used to reload the preserved data state to the start point of the critical path, e.g., at the data pin D of flip-flop FF1, after the adaptive test.

The adaptive check logic circuit 310 is illustrated as including adaptive check logic components 312 and 314 respectively connected to the data pin D and the output data pin Q of the flip-flop FF1, and which are connected via a loopback channel, illustrated with a dotted line, that is used to preserve and reload the data state of the start point of the critical path before and after the adaptive test. In some implementations, the adaptive check logic circuit 310 may include fewer components, e.g., only adaptive check logic components 312, which may use, e.g., a multiplexer based latch, to preserve and reload the data state of the start point of the critical path before and after the adaptive test.

Additionally, the adaptive check and control logic for critical path 140 includes a second adaptive check logic circuit 320, which includes at least one multiplexer, that is electrically connected to the end point of the critical path 140. The end point of the critical path, for example, is the end of the critical path where data is captured, e.g., the output data pin Q of flip-flop FF4, at a particular edge or level of a control signal, such as clock in synchronous circuits, such as received at the clock pin CP of flip-flop FF4. The at least one multiplexer in the adaptive check logic circuit 320 is used to preserve data state of the end point of the critical path, e.g., at the output data pin Q of flip-flop FF4, from before the adaptive test is performed. Additionally, the at least one multiplexer in the adaptive check logic circuit 320 is used to provide a timing violation signal indicative of a setup violation, a hold violation, or voltage violation in response to the adaptive check signal pattern during the adaptive test. Voltage violation, as used herein, is an indication that the voltage is out from a safe operating voltage range and may cause data corruption. Further, the at least one multiplexer in the adaptive check logic circuit 320 is used to reload the preserved data state to the end point of the critical path, e.g., at the output data pin Q of flip-flop FF4, after the adaptive test.

The adaptive check logic circuit 320 is illustrated as including adaptive test (AT) logic components 322 and 324 respectively connected to the data pin D and the output data pin Q of the flip-flop FF4, and which are connected via a loopback channel, illustrated with a dotted line, that is used to preserve and reload the data state of the end point of the critical path before and after the adaptive test. In some implementations, the adaptive check logic circuit 320 may include fewer components, e.g., only adaptive check logic components 314, which may use, e.g., a multiplexer based or latch based circuit, to preserve and reload the data state of the start point of the critical path before and after the adaptive test.

The adaptive check logic circuit 320 may produce an adaptive check output signal that is received by a scaling controller 330. The scaling controller 330, for example, may be an adaptive voltage scaling (AVS) circuit or dynamic-voltage-frequency-scaling (DVFS) circuit, or similar scaling controller that adjusts the adaptive voltage scaling and the control voltage of operation for a given operating frequency for the digital circuit 300 in response to the received adaptive check output signal.

The adaptive check and control logic for critical path 140 may further include clock gating to selectively enable and disable clock signals for the critical path start and end points, e.g., flip-flops FF1 and FF4, respectively, independently of rest of the flip-flops, e.g., flip-flops FF2 and FF3. For example, the adaptive check and control logic may include an integrated clock gating cell 340 that is electrically connected to the critical path 140, e.g., the clock pins CP of flip-flops FF1 and FF4. The integrated clock gating cell 340 receives a clock signal CLK on the clock pin CP, and an adaptive check clock enable signal avclken1 on an enable pin EN, and produces a clock signal CKL1 on the clock output pin CO. The integrated clock gating cell 340 selectively enables the functional clock signal CLK to the critical path 140 before and after the adaptive test and disables the functional clock signal CLK to the critical path 140 during the adaptive test. Additionally, the integrated clock gating cell 340 selectively disables an adaptive check clock signal to the critical path 140 before and after the adaptive test and enables the adaptive check clock signal to the critical path 140 during the adaptive test, e.g., by controlling the clock signal CLK to generate the desired adaptive check clock signal when the adaptive check clock enable signal avclken1 is enabled.

A second integrated clock gating cell 350 may be electrically connected to non-critical paths in the digital circuit 300, e.g., the clock pins CP of non-critical path flip-flops FF2 and FF3. The second integrated clock gating cell 350 receives a clock signal CLK on the clock pin CP, and a second adaptive check clock enable signal avclken2 on an enable pin EN, and produces a clock signal CKL2 on the clock output pin CO. The integrated clock gating cell 350 selectively enables the functional clock signal CLK to the non-critical paths before and after the adaptive test and disables the functional clock signal CLK during the adaptive test, e.g., via CLK2 to flip-flops FF2 and FF3. Other non-critical paths may or may not receive CLK2, but may receive another clock signal that will be gated using an additional clock gating cell.

Additionally, if combinational logic in the critical path includes a fan-in input from non-critical paths, the adaptive check and control logic for critical path 140 may include additional adaptive check logic circuits to provide state data to the combinational logic during the adaptive test to ensure that the adaptive check data pattern provided to the start point of the critical path is correctly propagated to the end point of the critical path. For example, as illustrated, flip-flops FF2 and FF3, are electrically connected to adaptive check logic circuits 362 and 364, respectively, each of which includes at least one multiplexer, that selectively provide state data to the combinational logic 110 during the adaptive test, but provide data from the flip-flops FF2 and FF3 before and after the adaptive test.

In addition to the configuration registers 130 for providing control settings for the digital circuit 300 and the adaptive check and control logic. The configuration registers may further provide indication of which critical path or group of critical paths (ATE Group) are being configured by the configuration register for adaptive testing, which is received by a controller 370. The controller 370 further receives an indication of when to perform the adaptive test (ATA), e.g., when the system is idle or a request for the adaptive test. The ATA signal, for example, is an overall enable signal received from software or hardware as a master control. The controller 370 may operate with software and/or hardware. For example, firmware may be used to decide, based on functionality, when to enable the adaptive check or hardware may be used to decide, e.g., on the basis of detecting idle time or on counter thresholds, to do self- checking in the system and provide status. The controller 370 may enable and disable the adaptive test and control the adaptive test process, e.g., by controlling the preservation and reloading of the data state of the beginning and end points of the critical path before and after the adaptive test, the configuration of test data during the adaptive test, and control of the adaptive clock signals to the critical path and components of non-critical paths during the adaptive test.

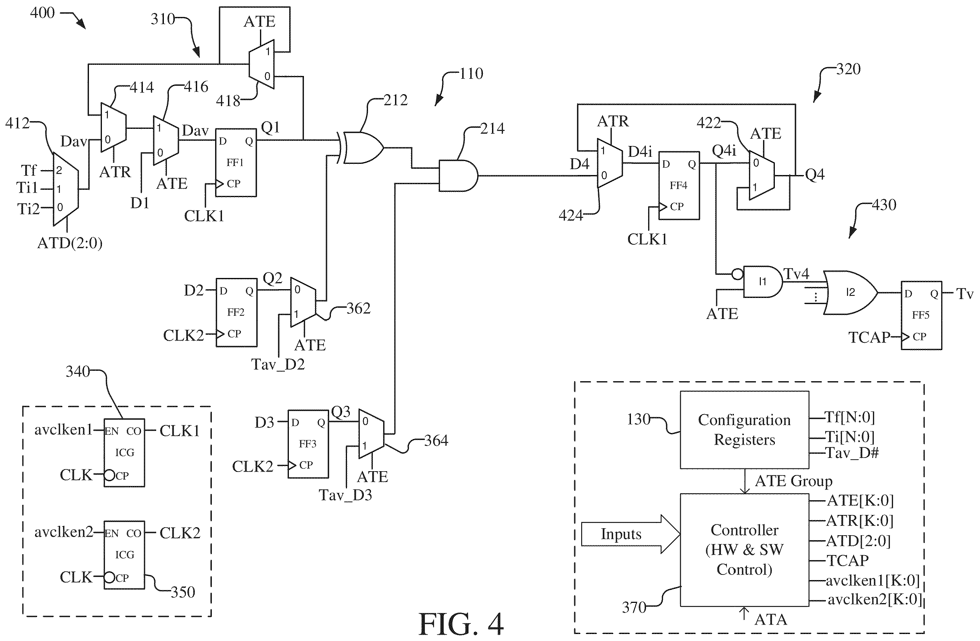

FIG. 4 illustrates an example pipeline architecture 400 for the critical path 140, with adaptive check and control logic, as illustrated in FIG. 3, like designated elements being the same. As illustrated in FIG. 2, the critical path 140 is the path from the input of the flip-flop FF1 through combinational logic 110, illustrated as including XOR gate 212 and AND gate 214, to the output of the flip-flop FF4.

As illustrated in FIG. 4, the adaptive check logic circuit 310 may include a set of multiplexers that are electrically connected to the start point of the critical path 140, e.g., the data pin D of flip-flop FF1, which are used to preserve functional data from before an adaptive test, insert the adaptive check pattern into the critical path during the adaptive test, and reload the preserved functional data back to the critical path after the adaptive test.

The adaptive check logic circuit 310, for example, may include a first multiplexer 412 that receives adaptive test data, shown as Tf (T-final), Ti1 (T-initial-1), and Ti2 (T-initial-2), which is selected by an ATD signal, and produces an output Dav. The test data Ti1 and Ti2, for example, are used to set correct values for the adaptive test data Dav, which propagates to outputs Q1, D4i and Qi4 on FF1, multiplexer 424, and FF4, respectively, during initialization of the time-check. The test data Tf is used to trigger the timing path during the check as the data launch to change the adaptive test data Dav, and therefore, at the output Q1 on the clock pulse on CLK1, which in return changes the output Qi4 on the next clock edge (in case of setup). A second multiplexer 414 receives the output from the first multiplexer 412 at a first input pin 0, a preserved data state for the flip-flop FF1 on a second input pin 1, and an adaptive test reload ATR signal on the selector pin. A third multiplexer 416 receives data D1 at a first input pin 0, and receives the output of the multiplexer 414, i.e., either the preserved data state for the flip-flop FF1 or the adaptive test data Dav, on a second input pin 1, and an adaptive test enable signal ATE on the selector pin. The output of the third multiplexer 416 is received by the data pin D of flip-flop FF1. Additionally, a fourth multiplexer 418 operates as a latch and receives the signal from the output data pin Q of the flip-flop FF1 at a first input pin 0, and connects the output of the multiplexer 418 to the second input pin 1, with the adaptive test enable signal ATE on the selector pin. The output of the fourth multiplexer 418 provides the preserved data state for the flip-flop FF1 to the second input pin 1 of multiplexer 414 in a loopback channel.

It should be understood that adaptive check logic circuit 310 may have other designs. For example, in some implementations, instead of using multiplexer 418 for preserving the state of output Q1 from the flip-flop FF1, other components such as a latch may be used for preserving the state of output Q1 from the flip-flip FF1 in a loopback channel from the output data pin Q to the data pin D of the flip-flop FF1. In some implementations, the multiplexers 414 and 416 may be included in the latch based loopback channel.

Additionally, as illustrated in FIG. 4, the adaptive check logic circuit 320 may include a set of multiplexers that are electrically connected to the end point of the critical path 140, e.g., the output data pin Q of flip-flop FF4, and is configured to preserve function data in the critical path from before an adaptive test, provide a timing violation signals during the adaptive test, and to reload the preserved functional data back to the critical path after the adaptive test. The adaptive check logic circuit 320, for example, may include a first multiplexer 422 that may operate as a latch for the output of the flip-flop FF4 by receiving the output signal Q4i from the output data pin Q of the flip-flop FF4 at a first input pin 0, and connecting the output Q4 of the multiplexer 422 to the second input pin 1, with the adaptive test enable signal ATE on the selector pin. A second multiplexer 424 receives the output signal from the combinational logic 110 on a first pin 0. The second multiplexer 424 is connected to the first multiplexer 422 in a loopback channel and receives the preserved data state for the flip-flop FF4 from the output of multiplexer 422 on a second input pin 1, and receives the adaptive test reload ATR signal on the selector pin. Additionally, the adaptive check logic circuit 320 may include a logic circuit, e.g., AND gate I1, to produce a timing violation signal Tv4 indicative of a setup violation or a hold violation in the critical path 140 in response to the adaptive check signal pattern during an adaptive test. The AND gate I1, for example, may receive the output signal Q41 from flip-flop FF4 at an inverted input pin, and the adaptive test enable signal ATE on the other input pin, and in response produce a timing violation signal Tv4 on the output pin. By way of example, the multiplexer 424 and 422 and AND gate I1 may be used as the AT logic 322 and 324 shown in FIG. 3.

It should be understood that adaptive check logic circuit 320 may have other designs. For example, in some implementations, instead of using multiplexer 422 for preserving the state of output Q4i from the flip-flop FF4, other components such as a latch may be used for preserving the state of output Q4i from the flip-flip FF4 in the loopback channel from the output data pin Q of the flip-flop FF4 to the data pine D of the flip-flop FF4. In some implementations, the multiplexer 424 may be included in the latch based loopback channel. In some implementations, a set of multiplexers similar to the set of multiplexers 414 and 416 used at the data pin D of flip-flop FF1, may be included in a multiplexer or latch based loopback channel to select the Ti# data may be provided to the data pin D of flip-flop FF4.

In addition, the adaptive check and control logic may include combinatorial logic 430 that receives timing violation signals for a plurality of critical paths in the integrated circuit and provides a common timing violation signal Tv indicating if there is any setup violation or the hold violation in any of critical paths in the integrated circuit during the adaptive test. For example, as illustrated, the combinatorial logic 430 may include an OR logic gate I2 that receives as inputs the timing violation signal Tv4 from the adaptive check logic circuit 320 and timing violation signal Tv4 from adaptive check logic circuits for other critical paths, and outputs the common timing violation signal Tv at input pin D of flip-flop FF5. The flip-flop FF5 latches the common timing violation signal and produces it on output pin Q in response to a timing event capture signal TCAP on the clock pin. The common timing violation signal Tv, for example, may be provided to a scaling controller, such as scaling controller 330 shown in FIG. 3.

As illustrated, the adaptive check logic circuits 362 and 364 connected to non-critical path flip-flops FF2 and FF3, respectively, may be multiplexers, that receive the output of the flip-flops on a first pin 0, and receive state data Tav_D2 and Tav_D3 on second pins 1, and the adaptive test enable signal ATE on the selector pin. In some implementations, the adaptive check logic circuits 362 and 364 may be logic AND and OR gates in place of multiplexers. The state data Tav_D# signals place the corresponding non-critical path flip-flop in the necessary state during an adaptive test and may be provided by the configuration registers 130. Additionally, as illustrated, the configuration register 130 may provide the Tf and Ti inputs and may provide an indication of which critical path or group of critical paths (ATE Group) are being tested, which is received by the controller 370. The controller 370 further receives an indication of when to perform the adaptive test (ATA), e.g., when the system is idle or a request for the adaptive test. The controller 370 may provide the adaptive test enable signal ATE, an adaptive test reload signal ATR, the adaptive test drive signal ATD, a test capture signal TCAP, and the adaptive check clock enable signals avclken1 and avclken2.

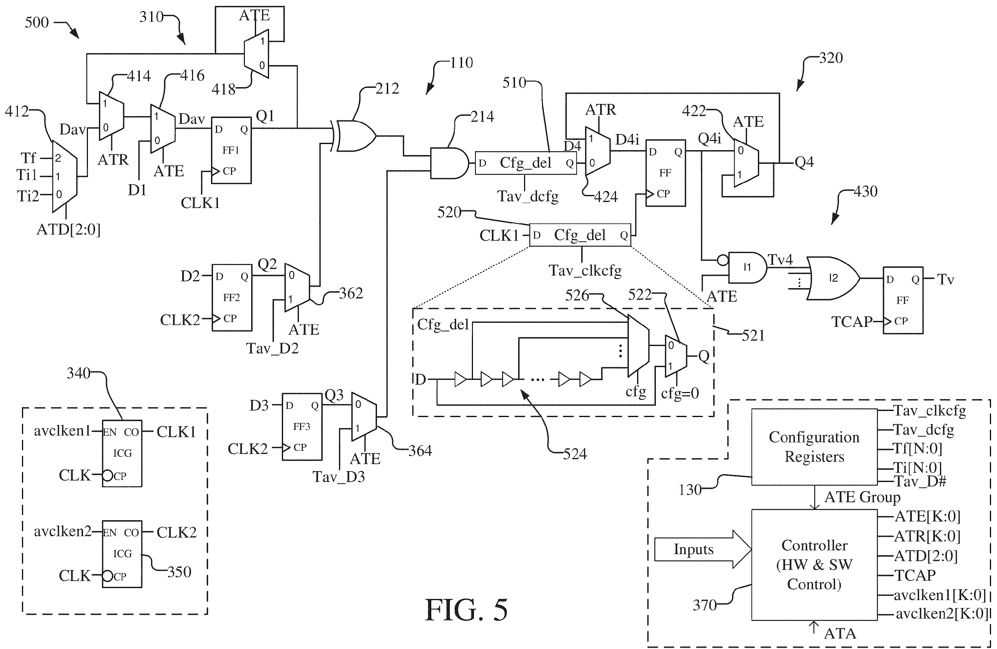

FIG. 5 illustrates an example pipeline architecture 500 for the critical path 140 with adaptive check and control logic, as illustrated in FIG. 4 like designated elements being the same, but additionally includes a data delay chain 510 and clock delay chain 520 before the end point of the critical path, i.e., flip-flop FF4.

As illustrated, the data delay chain 510 is connected to the data pin D of the destination flip-flop FF4, e.g., through multiplexer 424, and is controlled by an adaptive test data configuration Tav_dcfg signal. Data delay chain 510 enables a selection of different delays at the data pin D of the destination flip-flop FF4 to perform setup margin detection that is controlled by the adaptive test data configuration Tav_dcfg signal.

Similarly, the clock delay chain 520 is connected to the clock pin CP of the destination flip-flop FF4 and is controlled by an adaptive test clock configuration Tav_clkefg signal. Clock delay chain 520 similarly enables a selection of different delays at the clock pin CP of the destination flip-flop FF4 to perform hold-margin detection that is controlled by the adaptive test clock configuration Tav_clkcfg signal.

An implementation of clock delay chain 520 is illustrated in box 521. As illustrated, the clock delay chain 520 may include a multiplexer 522 that may selectively enable the clock signal for a daisy chain circuit. The daisy chain circuit may include a plurality of buffers 524 and another multiplexer 526 that is configured to select different numbers of buffers 524, e.g., based on the adaptive test clock configuration signal. The data delay chain 510 may have a similar implementation as clock delay chain 520, but may use additional or fewer buffers, and is controlled by the adaptive test data configuration Tav_dcfg signal.

The configuration registers 130 may provide the adaptive test data configuration Tav_dcfg signals and adaptive test clock configuration Tav_clkcfg signals to control the setup margin detection and the hold margin detection test.

The adaptive check and control logic for monitoring the performance of a critical path, as illustrated in FIGs. 3-5, selectively preserves the state of timing paths that are under test, e.g., the critical path, at the start of an adaptive test and reloads the preserved states back to the timing paths under test after the adaptive test and maintains the state of remaining logic during adaptive testing. The adaptive check and control logic may be applied to determine setup margins, hold margins, and voltage margins of the critical path at any given functional mode of the System on a Chip (SoC).

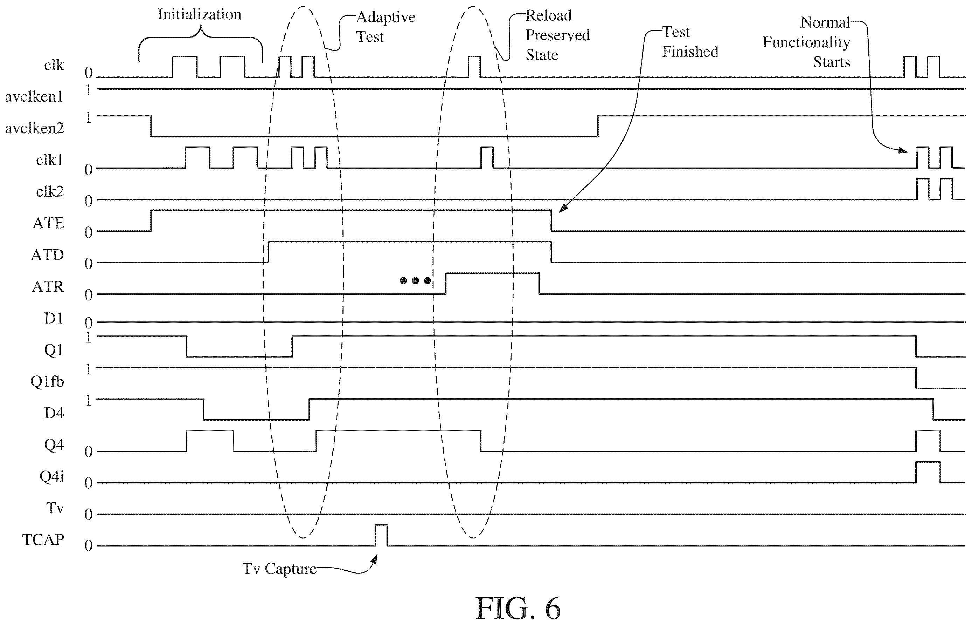

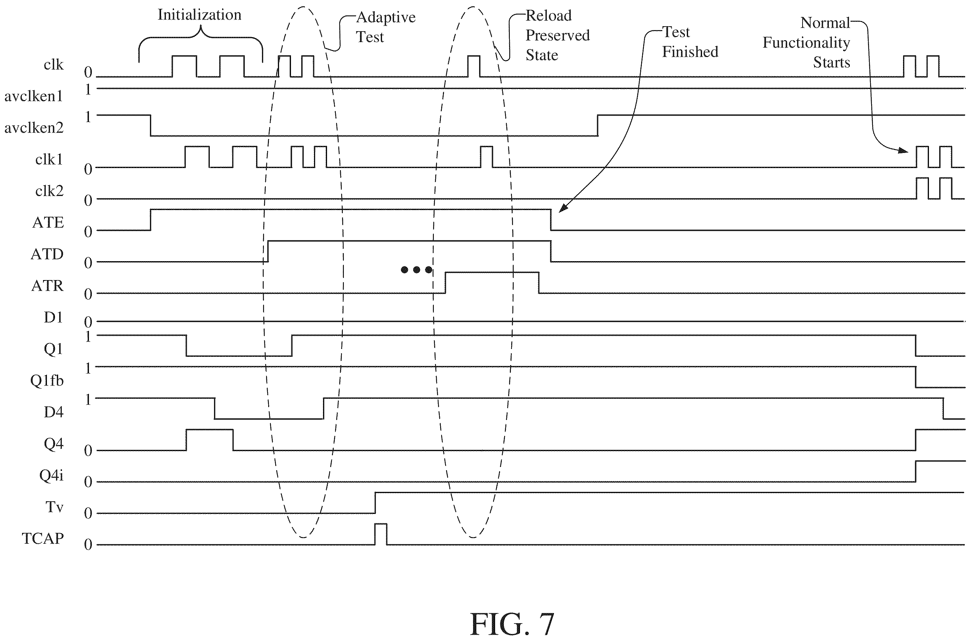

The adaptive check and control logic, e.g., illustrated in FIGs. 3-5, may be used for setup margin testing. For example, FIGs. 6 and 7 show waveforms illustrating a setup margin check using the adaptive check and control logic, as illustrated in FIGs. 3-5. FIGs. 6 and 7 illustrate a single iteration of the adaptive test. As indicated by the ellipsis, however, in operation multiple iterations of the adaptive test may be performed with a variation in one or more parameters as an independent variable(s). For example, in some implementations, the delay in the data path may be varied, e.g., using the data delay chain 510 before the flip-flop FF4, as shown in FIG. 5, to reduce the delay in the data path, to define the setup margin from functional to failure in terms of delay, e.g., the number of buffer elements. In some implementations, the delay in the data path may be kept in its functional mode, e.g., the daisy chain circuit may be bypassed by a multiplexer, or the data delay chain 510 may be absent from the critical path, as shown in FIG. 4, and the supply voltage may be varied in specific step sizes to reduce the supply voltage to define the setup margin from functional to failure in terms of voltage, e.g., the number of voltage steps. Thus, the setup margin may be determined in terms of buffer delay or voltage margin. In some implementations, the delay in the data path may be kept in its functional mode and the voltage may be kept constant, and the frequency of the capture clock may be increased in specific step sizes to define the setup margin from functional to failure in terms of clock frequency, e.g., the number of phase lock loop (PLL) or clock-controller steps. Determining the setup margin in terms of frequency, for example, may be particularly useful where over speeding the clock may be beneficial to increase performance of the circuit. In some implementations, one or more combinations of independent variable parameters may be used to determine the setup margin in terms of some combination of delay, voltage, and frequency.

Additionally, in some implementations, when the operating voltage is near or sub-threshold, the setup margin check may be performed irrespective of whether the voltage step is increasing or decreasing supply voltage. Thus, the setup margin check may cross-check the pass/fail by monitoring without changing anything else. For example, the monitoring may be performed on a periodic interval to validate the pass condition.

As illustrated in FIGs. 6 and 7, and referencing the circuit diagrams shown in FIGs. 3-5, during an initialization of the adaptive check, the adaptive test is enabled by transitioning the adaptive test enable value to high (ATE=1), while the adaptive test reload ATR and the adaptive test drive ATD values are held at low (0), which preserves the state of the flip-flops FF1 and FF4 in the critical path. Other non-critical path signals that impact the critical path, e.g., signals from flip-flops FF2 and FF3, are configured to static values, e.g., using Tav_D2 and Tav_D3, respectively, that enable testing of the critical path. The start point and the end point of the critical path, e.g., flip-flops FF1 and FF4, are initialized with data using the Ti# inputs at multiplexer 412 and, as illustrated in FIGs. 6 and 7, and by providing two clock pulses, which may be low frequency to ensure correct data capture on critical path flip-flops FF1 and FF2. The two clock pulses are provided only to the components in the critical path due to the adaptive check clock enable signal avclken1 at the integrated clock gating cell 340 thereby initializing the data at Q1 and Q4, while non-critical path components, e.g., flip-flops FF3 and FF4, have their clock signal gated due to the adaptive check clock enable signal avclken2 at the integrated clock gating cell 350. The adaptive test drive ATD is incremented to initialize the path and select the launch data for the desired timing-arc.

The adaptive test may then be performed by generating two functional frequency, i.e., normal frequency, clock cycles. The first clock cycle is for the data launch at the start point of the critical path, e.g., flip-flop FF1, and the second data cycle is for the data capture at the end point of the critical path, e.g., flip-flop FF4. The output generated at the end of the critical path, e.g., output Q4i produced by flip-flop FF4, may be compared with the expected output by a logic circuit, e.g., using AND gate I1 shown in FIGs. 4 and 5, and a timing violation, e.g., on signal Tv4, may be generated if there is a mismatch. All the critical paths are similarly tested and the output of each critical path compared to an expected value to produce timing violation signals for each critical path, which are provided to a logic circuit, e.g., OR gate I2, to generate a common timing-violation signal Tv that may be captured using a timing event capture signal TCAP.

During the adaptive test, clock signals in the circuit are controlled, e.g., using clock gating cells 340 and 350, based on the enable signals avclken1 and avclken2. Controlling the clock signal in the circuit is done to clock only selected components of the critical paths using clock signal CLK1, while stopping the clock for the remaining components in the circuit clock using clock signal CLK2 to preserve data at these remaining components.

As indicated by the ellipsis in FIGs. 6 and 7, the adaptive test may be repeated multiple times, with one or more parameters varied in steps to determine the setup margin in terms of the one or more independent variables. For example, the setup margin may be determined in terms of delay elements, e.g., buffer count, using the data delay chain 510 before the data pin D of the flip-flop FF4, as shown in FIG. 5. The adaptive test data configuration Tav_dcfg signals may be used to alter the number of delay elements, e.g., alter the buffer count, in the path for each iteration of the setup margin test. This process may be performed using a decreasing number of delay elements until a timing violation is detected (functional to failure), or with an increasing number of delay elements until a timing violation is no longer detected (failure to functional) at which time the minimum setup margin can be determined. In another implementation, the supply voltage may be varied to perform a voltage margin test for maximum speed, i.e., setup, for example, by decreasing the supply voltage in specific step sizes, for each adaptive test iteration, until a timing violation is detected, at which time the minimum supply voltage necessary for the setup margin can be determined. For example, if the voltage step size is 10mV for DCDC, and three steps from the operating voltage were required to cause design failure, then the setup margin may be defined as two steps, e.g., 20mV, of voltage source. In another implementation, the frequency of the clock may be varied until a timing violation is detected, at which time the maximum frequency for the setup margin may be determined.

Once the adaptive test is completed, the preserved states from the start and end points of the critical path are reloaded. For example, the adaptive test reload is enabled by incrementing the adaptive test reload value (ATR=1) and a single clock pulse is used to reload the data back on critical path flip-flops FF1 and FF4. After that, the adaptive test is finished and the adaptive test is disabled, e.g., e.g., the adaptive test enable ATE, adaptive test drive ATD and adaptive test reload ATR values are pulsed down to '0'; followed by normal functional operation.

It should be understood that the adaptive check and control logic may be modified or varied, as discussed above, which may correspondingly alter the waveforms. For example, in some implementations, the circuit may be designed to initialize the launch and capture of data at flip-flops FF1 and FF4 in a single clock cycle, i.e., only requiring a single cycle initialization. For example, a single cycle initialization may be performed using a set of multiplexers at the data pin D of flip-flop FF4 that is similar to the set of multiplexers used at the data pin D of flip-flop FF1 to select the Ti# data. Other optimizations and flexible variants may be similarly performed if desired.

FIG. 6, by way of example, illustrates a setup margin test waveform with no timing violation detected, while FIG. 7 illustrates a setup margin test waveform when a timing violation is detected. The critical path under test is from Q1 to Q4 with a rise transition on Q4, i.e., from '0' to '1,' which requires that Q1 transitions from '0' to '1' for the given example of logic. During the initialization phase, the two slow, low frequency, clock cycles ensures that Q1 and Q4 are '0' before the start of the adaptive test capture phase clock cycles; this is done using desired values on Ti1 & Ti2 (as in this example Ti1 and Ti2 are both '0', circuit implementation may be optimized to single bit Ti and single bit ATD). During the capture phase, the first clock pulse (on clk1 during the adaptive test) launches data ('1') on Q1, based on the value on Tf, followed by the second clock pulse (on clk1 during the adaptive test) to capture the data on Q4. As illustrated in FIG. 6, D4 transitions high ('1) before the second clock pulse and Q4 transitions high on the second clock pulse. As illustrated in FIG. 7, however, D4 transitions high ('1') after the second clock pulse, and accordingly, Q4 fails to transition high on the second clock pulse resulting in a timing violation. After the second clock pulse, the timing event capture signal TCAP is used to latch the common timing violation signal Tv. As discussed above, and illustrated by ellipsis, multiple repetitions may be performed with different numbers of delay buffers, or different voltages, or different clock frequencies, to determine at which step the circuit transitions from functional to failure, or vice versa from failure to functional. Once the adaptive test is completed, the reload cycle is performed, which puts the Q1 and Q4 back to their functional states, so that the D4 is recovered to its valid value when the test is finished (i.e., when ATE is pulsed down to '0').

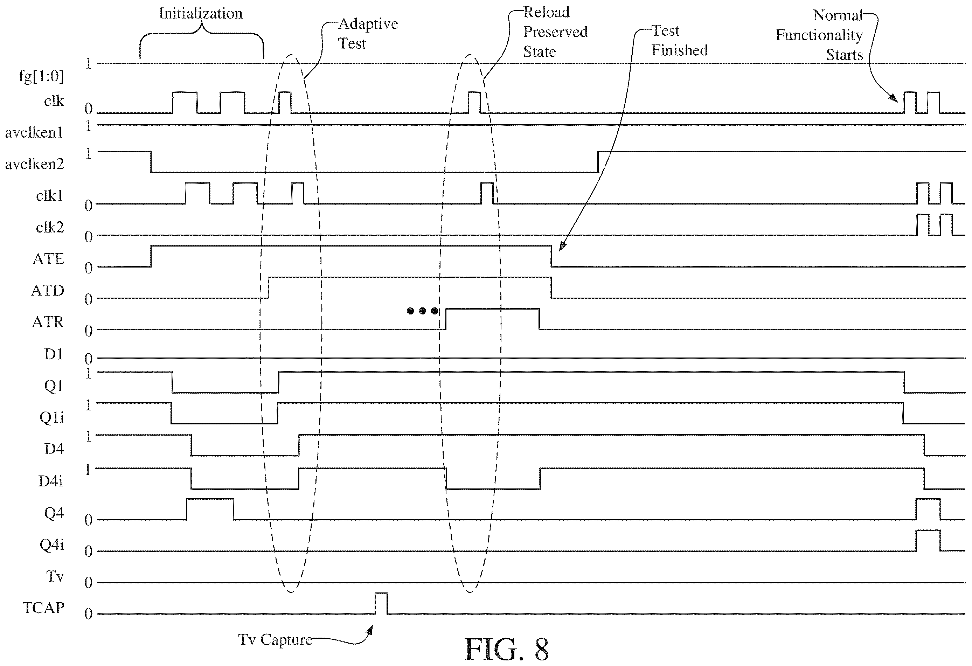

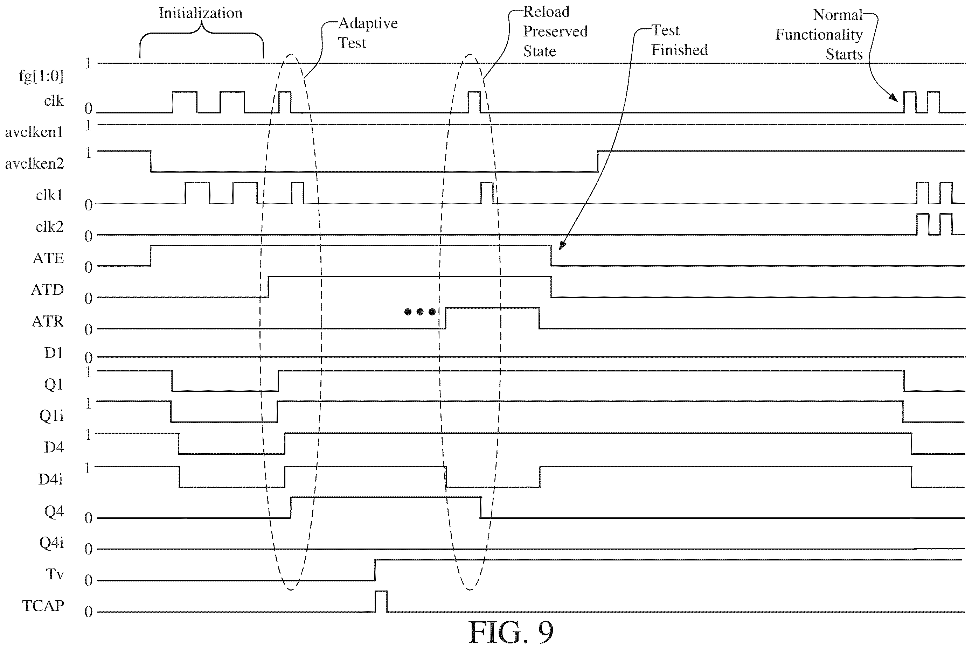

The adaptive check and control logic, e.g., illustrated in FIGs. 3-5, may be used for hold margin testing. For example, FIGs. 8 and 9 show waveforms illustrating a hold margin check using the adaptive check and control logic, as referred to in illustrated in FIGs. 3-5. FIGs. 8 and 9 illustrate a single iteration of the adaptive test. As indicated by the ellipsis, however, in operation multiple iterations of the adaptive test may be performed with a variation in one or more parameters as an independent variable(s). For example, in some implementations, the delay in the clock signal may be varied, e.g., using the clock delay chain 520 before the flip-flop FF4, as shown in FIG. 5, to increase the delay in the clock path, to define the hold margin from functional to failure in terms of delay, e.g., the number of buffer elements. In some implementations, the delay in the clock path may be kept in its functional mode, e.g., the daisy chain circuit may be bypassed by a multiplexer, or the clock delay chain 520 may be absent from the critical path, as shown in FIG. 4, and the supply voltage may be varied in specific step sizes to increase the supply voltage to define the hold margin from functional to failure in terms of voltage, e.g., the number of voltage steps. In some implementations, one or more combinations of independent variable parameters may be used to determine the hold margin in terms of some combination of delay and voltage.

Additionally, in some implementations, when the operating voltage is near or sub-threshold, the hold margin check may be performed irrespective of whether the voltage step is increasing or decreasing supply voltage. Thus, the hold margin check may cross-check the pass/fail by monitoring without changing anything else. For example, the monitoring may be performed on a periodic interval to validate the pass condition.

The hold margin check illustrated by the waveforms in FIGs. 8 and 9 is similar to the setup margin check illustrated by the waveforms illustrated in FIGs. 6 and 7. The hold margin check, however, determines whether launched data on the clock (adaptive test) reaches the destination too fast, e.g., whether the data on Q4i is changed by mistake (due to hold timing failure) on the clock cycle where Q1 is changed. Accordingly, the hold margin check may use a single clock cycle for the adaptive test, instead of two clock cycle used for the setup margin check. Additionally, to determine the hold margin in terms of the number of delay elements, the process may be repeated multiple times, e.g., with different delay configurations in the clock delay chain 520 before the clock pin CP of the flip-flop FF4shown in FIG. 5, instead of different delay configurations in the data path used for the setup margin check. The adaptive test data configuration Tav_clkcfg signals may be used to alter the number of delay elements, e.g., alter the buffer count, in the clock path for each iteration of the hold margin test. This process may be repeated until a timing violation is detected; at which time the minimum hold margin can be determined. In an implementation in which the supply voltage is varied to determine the hold margin in terms of voltage steps, the clock delay chain 520 may be absent or not used.

FIG. 8, by way of example, illustrates a hold margin test waveform with no timing violation detected, e.g., number of delay elements selected by the adaptive test clock configuration Tav_clkcfg value, is sufficient for the hold margin requirement to be met. FIG. 9, on the other hand, illustrates a hold margin test waveform when a timing violation is detected, e.g., the number of delay elements selected by the adaptive test clock configuration av_clkcfg is large enough to cause a hold violation, therefore, generating the timing violation (Tv).

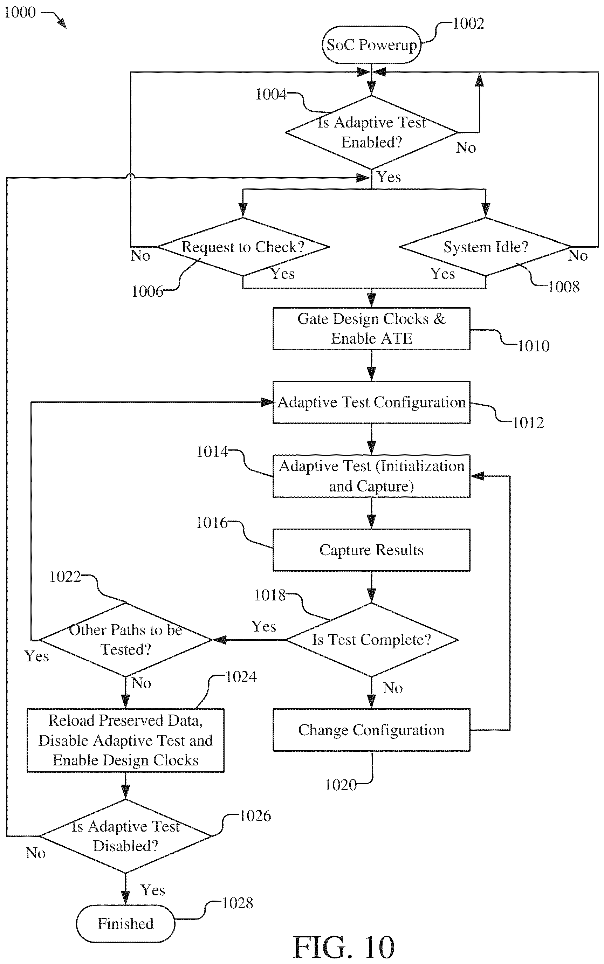

FIG. 10 is a flow chart illustrating an example of controlling the adaptive testing process 1000 using the adaptive check and control logic, including controller 370 discussed herein and illustrated in FIGs. 3-5.

As illustrated, after powerup of the System on a Chip (SoC) (1002), the controller determines whether adaptive testing is enabled (1004), e.g., whether a scaling controller, such as scaling controller shown in FIG. 3, is operable to adaptively control the voltage and/or frequency of operation for the SoC in response to adaptive test results. Once adaptive testing is enabled, the controller awaits an appropriate time to perform the adaptive testing, such as after receiving a specific request to check (1006), e.g., which may be issued based on functionality of the circuit or when a counter threshold for self-checking is reached, or when detecting that the system is idle (1008).

When the controller determines that the adaptive test is to be performed, e.g., after receiving a request to check (1006) or the system is in idle mode (1008), the design clocks are gated, e.g., using enable signals avclken1 and avclken2 from clock gating cells 340 and 350, and the adaptive test enable ATE signal is incremented (1010), e.g. to preserve the data from the start and end points of the critical path. The adaptive test configuration is then provided to the circuit (1012), including the start and end points of the critical path and the components of non-critical paths, e.g., via the adaptive test drive ATD signal. For example, the adaptive test configuration may be used to select setup margin detection, hold margin detection or voltage margin for setup or hold detection, as discussed above. Additionally, the adaptive test configuration may select one or a group of critical paths to be tested. The adaptive test may then be performed, including initialization of the critical path(s) and capture of the test data by the end point of the critical path(s) (1014). The results of the adaptive test are then captured (1016), e.g., based on the timing event capture signal TCAP. The controller determines if the test is complete (1018), e.g., whether all desired iterations have been performed or a test failure result has been received, and if not, the adaptive test configuration is changed (1020) and the process returns to perform the adaptive test, including initialization and capture (1014). For example, the type of adaptive test may be altered for a selected critical path or group of critical paths. Additionally, the adaptive test configuration may be performed on multiple groups of critical paths. Each group may be selected by the adaptive test configuration and once one group is complete, the adaptive test configuration is changed (1020) so that the next group of critical paths may be tested.

Once the test is complete (1018), the controller determines whether there are other critical paths to be tested (1022). For example, in some implementations, multiple critical paths may be tested separately, while in other implementations, multiple critical paths may be simultaneously tested during the adaptive test process illustrated in blocks 1012-1016, with the test results logically combined to generate a common test result, but the SoC may have one or more additional critical paths that may be tested separately. If other critical paths are to be tested (1022), the process returns to perform the adaptive test configuration (1012) for these additional critical paths.

If no other critical paths are to be tested (1022), the controller reloads preserved data to the start and end points of the critical path, e.g. via the adaptive test reload ATR signal, disables the adaptive test enable ATE signal, and enables the design clocks (1024), e.g., via the enable signals avclken1 and avclken2 from clock gating cells 340 and 350. The controller may then determine if the adaptive test is disabled (1026); if not, the process returns to blocks 1006 and 1008, and if so, the process is finished (1028).

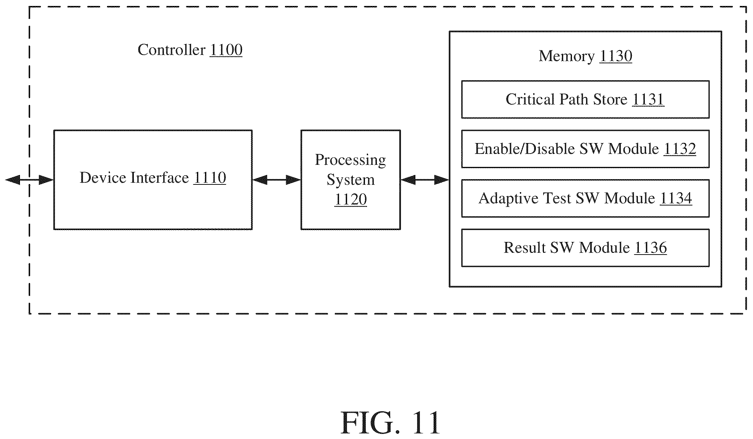

FIG. 11 shows a block diagram of an example controller 1100 that may be used with the adaptive check and control logic discussed herein, according to some implementations. In some implementations, the controller 1100 may be one example of the controller 370 of FIGs. 3-5, and may be used to control the adaptive testing process 1000 illustrated in FIG. 10. The controller 1100 includes a device interface 1110, a processing system 1120, and a memory 1130.

The device interface 1110 is configured to communicate with one or more components of the adaptive check and control logic discussed herein. The device interface 1110, for example, may be configured to receive various inputs, e.g., including an indication of which critical path or group of critical paths (ATE group) is being tested, an indication when adaptive testing is enabled, e.g., by a scaling controller, an indication of when the system is in idle, and requests for adaptive checks. The device interface 1110 further may be configured to provide various adaptive test enable/disable signals, such as the adaptive test enable signal ATE, an adaptive test reload signal ATR, the adaptive test drive signal ATD, a test capture signal TCAP, and the adaptive check clock enable signals avclken1 and avclken2.

The memory 1130 may include critical path store 1131 configured to store configurations of critical paths or groups of critical paths. The memory 1130 also may include a non-transitory computer-readable medium (including one or more nonvolatile memory elements, such as EPROM, EEPROM, Flash memory, or a hard drive, among other examples) that may store at least the following software (SW) modules:
- an enable and disable SW module 1132 to control the enablement and disablement of adaptive tests to one or more critical paths, including the preserving and reloading state data in the beginning and end points of critical paths before and after adaptive tests, providing adaptive test data configurations to the start and end points of the critical path and components of non-critical paths;
- an adaptive test SW module 1134 to control the adaptive test, including controlling the initialization and capture of data during an adaptive test and varying configurations, such as the number of delay elements, voltage levels, clock frequency, etc. in different iterations of the adaptive test;
- a result SW module 1136 to control the reception and processing of timing violation results during adaptive testing, including providing an indication of the results to the adaptive test SW module 1134 to continue iterating or stopping the adaptive testing and to a scaling controller, e.g. scaling controller 330 in FIG. 3, to adapt the supply voltage and/or the clock frequency accordingly;
Each software module includes instructions that, when executed by the processing system 1120, causes the controller 1100 to perform the corresponding functions.

The processing system 1120 may be configured to implement the functionality discussed herein using hardware, software, or a combination of hardware and software. For example, the functionality discussed herein may be hardcoded in logic in the processing system 1120, or may be executed by any suitable one or more processors capable of executing scripts or instructions of one or more software programs stored in the controller 1100 (such as in the memory 1130) such as the enable and disable SW module 1132, the adaptive test SW module 1134, and the result SW module 1136, or in a combination of hardcoded logic and execution of software instructions stored in memory. For example, the processing system 1120 may be configured to control the enablement and disablement of adaptive tests to one or more critical paths, including the preserving and reloading state data in the beginning and end points of critical paths before and after adaptive tests, providing adaptive test data configurations to the start and end points of the critical path and components of non-critical paths. The processing system 1120 also may be configured to control the adaptive test performed by the adaptive check and control logic, including controlling the initialization and capture of data during an adaptive test and varying configurations, such as the number of delay elements, voltage levels, clock frequency, etc. in different iterations of the adaptive test. The processing system 1120 also may be configured to control the reception and processing of timing violation results during adaptive testing, including providing an indication of the results to continue iterating or stopping the adaptive testing and to a scaling controller, e.g., scaling controller 330 in FIG. 3, to adapt the supply voltage and/or the clock frequency accordingly.

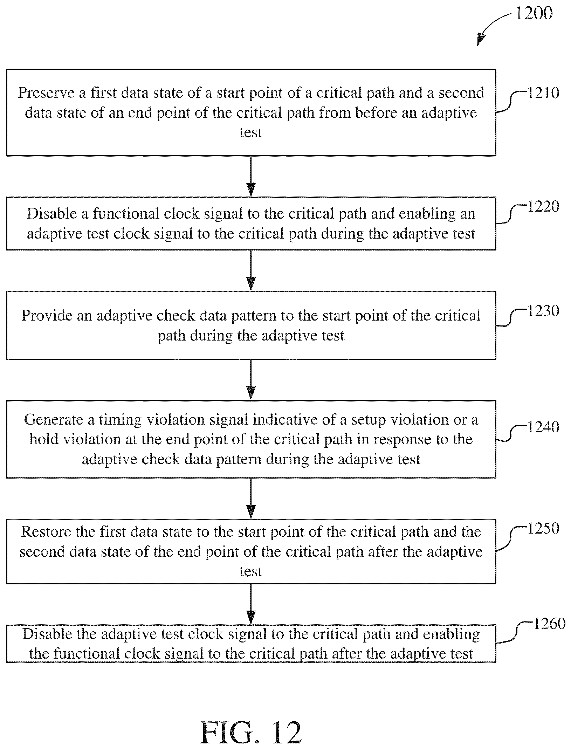

FIG. 12 shows an illustrative flowchart depicting an example method 1200 for monitoring performance of an integrated circuit, according to some implementations. In some implementations, the example method 1200 may be performed by the adaptive check and control logic illustrated in FIGs. 3-5 and waveforms shown in FIGs. 6-9, and may be controlled by a controller, as discussed in reference to FIGs. 10 and 11.

As illustrated in FIG. 12, a first data state of a start point of a critical path and a second data state of an end point of the critical path are preserved before an adaptive test (1210). The preservation of the first data state of the start point of the critical path, for example, may be performed by a first adaptive voltage check logic circuit that includes a first state preserving electrical component including one of a multiplexer or latch that is coupled to the start point of a critical path in the integrated circuit, such as adaptive check logic circuit 310 connected to flip-flop FF1 shown in FIGs. 3-5, in response to an adaptive test enable signal ATE from controller 370. The preservation of the second data state of the end point of the critical path, for example, may be performed by a second adaptive check logic circuit that includes a second state preserving electrical component comprising one of a multiplexer or latch coupled to the end point of the critical path in the integrated circuit, such as adaptive check logic circuit 320 connected to flip-flop FF4 shown in FIGs. 3-5, in response to the adaptive test enable signal ATE from controller 370.

The method includes disabling a functional clock signal to the critical path and enabling an adaptive test clock signal to the critical path during the adaptive test (1220), e.g., by an integrated clock gating cell coupled to the critical path such as the integrated clock gating cell 340 that is connected to the clock pins CP of flip-flops FF1 and FF4, in response to an adaptive check clock enable signal avclken1 from controller 370.

An adaptive check data pattern is provided to the start point of the critical path during the adaptive test (1230), e.g., by the first adaptive voltage check logic circuit that includes the at least one multiplexer coupled to the start point of a critical path in the integrated circuit, such as the adaptive check logic circuit 310 connected to flip-flop FF1 shown in FIGs. 3-5, in response to the adaptive test drive signal ATD from controller 370.

A timing violation signal indicative of at least one of a setup violation, a hold violation, or voltage violation is generated at the end point of the critical path in response to the adaptive check data pattern during the adaptive test (1240), e.g., by the second adaptive voltage check logic circuit that includes the second at least one multiplexer coupled to the end point of the critical path in the integrated circuit, such as the adaptive check logic circuit 320 connected to flip-flop FF4 shown in FIGs. 3-5, in response to the timing event capture signal TCAP from controller 370.

The method includes restoring the first data state to the start point of the critical path and the second data state of the end point of the critical path after the adaptive test (1250). The restoring of the first data state to the start point of the critical path, for example, may be performed by the first adaptive voltage check logic circuit that includes at least one multiplexer coupled to the start point, such as the adaptive check logic circuit 310 connected to flip-flop FF1 shown in FIGs. 3-5, in response to an adaptive test reload signal ATR from controller 370. The restoring of the second data state to the end point of the critical path, for example, may be performed by the second adaptive check logic circuit that includes the second at least one multiplexer coupled to the end point, such as the adaptive check logic circuit 320 connected to flip-flop FF4 shown in FIGs. 3-5, in response to the adaptive test reload signal ATR from controller 370.

The method further includes disabling the adaptive test clock signal to the critical path and enabling the functional clock signal to the critical path after the adaptive test (1260), e.g., by the integrated clock gating cell coupled to the critical path such as the integrated clock gating cell 340 that is connected to the clock pins CP of flip-flops FF1 and FF4, in response to the adaptive check clock enable signal avclken1 from controller 370.

In some implementations, preserving the first data state and restoring the first data state may a first loopback channel that is coupled to one of a first multiplexer or latch circuit coupled to the start point of the critical path, e.g., as illustrated by the adaptive check logic circuit 310 connected to flip-flop FF1 shown in FIGs. 3-5, and preserving the second data state and restoring the second data state uses a second loopback channel that is coupled to one of a second multiplexer or latch circuit coupled to the end point of the critical path, e.g., as illustrated by the adaptive check logic circuit 320 connected to flip-flop FF4 shown in FIGs. 3-5.

In some implementations, during the adaptive test, the method may further include providing state data from a non-critical path that is coupled to the critical path through combinatorial logic, e.g., using a third adaptive check logic circuit that includes a third at least one multiplexer or logic AND and OR gates coupled to the non-critical path, such as illustrated by the adaptive check logic circuit 362 connected to the flip-flip FF2 in response to the adaptive test enable signal ATE from controller 370.

In some implementations, the adaptive check data pattern may be provided to a data pin of the end point of the critical path through a delay chain circuit during the adaptive test for setup margin detection, e.g., as illustrated by the data delay chain 510 connected to the flip-flop FF4. For example, different pluralities of buffers in the delay chain circuit may be selectively connected to the data pin of the end point of the critical path during the adaptive test for at least one of setup margin detection in terms of buffer count, voltage margin detection towards lower side in terms of buffer count, or clock speed margin detection in terms of buffer count, e.g., as illustrated by the plurality of buffers 524 shown in FIG. 5 and discussed in reference to the waveforms shown in FIGs. 6 and 7.

In some implementations, the adaptive test clock signal may be provided to a clock pin of the end point of the critical path through a delay chain circuit during the adaptive test for hold-margin detection, e.g., as illustrated by the clock delay chain 520 connected to the flip-flop FF4. For example, different pluralities of buffers in the delay chain circuit may be selectively connected to the clock pin of the end point of the critical path during the adaptive test for at least one of hold-margin detection in terms of buffer count or voltage margin detection toward higher side in terms of buffer count, e.g., as illustrated by the plurality of buffers 524 shown in FIG. 5 and discussed in reference to the waveforms shown in FIGs. 8 and 9.

In some implementations, the method includes providing an indication of the timing violation signal to an adaptive voltage scaling circuit, e.g., as illustrated by scaling controller 330 in FIG. 3.

In some implementations, the method includes performing at least one of setup margin detection and hold-margin detection in terms of voltage step count based on the timing violation signal, e.g., as discussed in reference to the waveforms shown in FIGs. 6-9.

In some implementations, the method includes performing setup margin detection in terms of clock signal step count based on the timing violation signal, e.g., as discussed in reference to the waveforms shown in FIGs. 6 and 7.

In some implementations, the method may further include disabling the functional clock signal to a non-critical path during the adaptive test, and enabling the functional clock signal to the non-critical path before and after the adaptive test, e.g., as illustrated by the integrated clock gating cell 350 that is connected to the clock pins CP of flip-flops FF2 and FF3, in response to the adaptive check clock enable signal avclken2 from controller 370.

In some implementations, the timing violation signal associated with the critical path is combined with one or more additional timing violation signals associated with one or more other critical paths in the integrated circuit with combinatorial logic to generate a common timing violation signal, e.g., as illustrated by combinatorial logic 430 shown in FIGs. 4 and 5.

In some implementations, the timing violation signal is used for monitoring at least one of voltage or frequency scaling for the integrated circuit. The monitoring may be initiated in response to an indication that the integrated circuit is in an idle state or in regular time intervals, e.g., as discussed in reference to FIGs. 10 and 11. The initiation of monitoring, for example, may be performed by a controller using hardware or software.

Those of skill in the art will appreciate that information and signals may be represented using any of a variety of different technologies and techniques. For example, data, instructions, commands, information, signals, bits, symbols, and chips that may be referenced throughout the above description may be represented by voltages, currents, electromagnetic waves, magnetic fields or particles, optical fields or particles, or any combination thereof.

Further, those of skill in the art will appreciate that the various illustrative logical blocks, modules, circuits, and algorithm steps described in connection with the aspects disclosed herein may be implemented as electronic hardware, computer software, or combinations of both. To clearly illustrate this interchangeability of hardware and software, various illustrative components, blocks, modules, circuits, and steps have been described above generally in terms of their functionality. Whether such functionality is implemented as hardware or software depends upon the particular application and design constraints imposed on the overall system. Skilled artisans may implement the described functionality in varying ways for each particular application, but such implementation decisions should not be interpreted as causing a departure from the scope of the disclosure.

The methods, sequences or algorithms described in connection with the aspects disclosed herein may be embodied directly in hardware, in a software module executed by a processor, or in a combination of the two. A software module may reside in RAM memory, flash memory, ROM memory, EPROM memory, EEPROM memory, registers, hard disk, a removable disk, a CD-ROM, or any other form of storage medium known in the art. An exemplary storage medium is coupled to the processor such that the processor can read information from, and write information to, the storage medium. In the alternative, the storage medium may be integral to the processor.

In the foregoing specification, implementations have been described with reference to specific examples thereof. It will, however, be evident that various modifications and changes may be made thereto without departing from the broader scope of the disclosure as set forth in the appended claims. The specification and drawings are, accordingly, to be regarded in an illustrative sense rather than a restrictive sense.

## Claims

1. An apparatus for monitoring performance of an integrated circuit, the apparatus comprising:
a first adaptive check logic circuit comprising a first state preserving electrical component comprising one of a multiplexer or latch that is coupled to a start point of a critical path in the integrated circuit, wherein the first adaptive check logic circuit comprising the first state preserving electrical component preserves a first data state of the start point of the critical path from before an adaptive test, provides an adaptive check data pattern to the start point of the critical path during the adaptive test, and reloads the first data state to the start point of the critical path after the adaptive test;
a second adaptive check logic circuit comprising a second state preserving electrical component comprising one of a multiplexer or latch that is coupled to an end point of the critical path in the integrated circuit, wherein the second adaptive check logic circuit comprising the second state preserving electrical component preserves a second data state of the end point of the critical path from before the adaptive test, provides a timing violation signal indicative of at least one of a setup violation, a hold violation, or a voltage violation in response to the adaptive check data pattern during the adaptive test, and reloads the second data state to the end point of the critical path after the adaptive test; and
an integrated clock gating cell coupled to the critical path, the integrated clock gating cell selectively enables a functional clock signal to the critical path and disables an adaptive test clock signal to the critical path before and after the adaptive test and selectively disables the functional clock signal to the critical path and enables the adaptive test clock signal to the critical path during the adaptive test.

2. The apparatus of claim 1, wherein the first state preserving electrical component further comprises a first loopback channel coupled to the multiplexer or latch that preserves the first data state of the start point of the critical path from before the adaptive test and reloads the first data state to the start point of the critical path after the adaptive test, and wherein the second state preserving electrical component further comprises a second loopback channel coupled to the multiplexer or latch that preserves the second data state of the end point of the critical path from before the adaptive test and reloads the second data state to the end point of the critical path after the adaptive test.

3. The apparatus of claim 1, further comprising a third adaptive check logic circuit comprising a third at least one multiplexer coupled to a non-critical path that is coupled to the critical path through combinatorial logic, wherein the third adaptive check logic circuit comprising the third at least one multiplexer provides state data to the combinatorial logic during the adaptive test.

4. The apparatus of claim 1, further comprising a delay chain circuit comprising at least one multiplexer coupled to a data pin of the end point of the critical path, wherein the delay chain circuit comprising the at least one multiplexer is selectively enabled during the adaptive test for setup margin detection, wherein the delay chain circuit further comprises a plurality of buffers that are selectively coupled to the data pin of the end point of the critical path during the adaptive test for at least one of setup margin detection in terms of buffer count, voltage margin detection in terms of buffer count, or clock speed margin detection in terms of buffer count.

5. The apparatus of claim 1, further comprising a delay chain circuit comprising at least one multiplexer coupled to a clock pin of the end point of the critical path, wherein the delay chain circuit comprising the at least one multiplexer is selectively enabled during the adaptive test for hold-margin detection, wherein the delay chain circuit further comprises a plurality of buffers that are selectively coupled to the clock pin of the end point of the critical path during the adaptive test for at least one of hold-margin detection in terms of buffer count or voltage margin detection in terms of buffer count.

6. The apparatus of claim 1, further comprising an adaptive voltage scaling circuit that is coupled to the second adaptive check logic circuit; or
wherein the timing violation signal is used for at least one of setup margin detection and hold-margin detection in terms of voltage step count; or
wherein the timing violation signal is used for setup margin detection in terms of clock signal step count.

7. The apparatus of claim 1, further comprising a second integrated clock gating cell coupled to a non-critical path that is coupled to the critical path through combinatorial logic, the second integrated clock gating cell selectively enables the functional clock signal to the non-critical path before and after the adaptive test and selectively disables the functional clock signal to the non-critical path during the adaptive test.

8. The apparatus of claim 1, further comprising combinatorial logic coupled to receive the timing violation signal associated with the critical path and one or more additional timing violation signals associated with one or more other critical paths in the integrated circuit and to provide an indication of the setup violation or the hold violation in any of critical path in the integrated circuit during the adaptive test.

9. A method for monitoring performance of an integrated circuit, the method comprising:
preserving a first data state of a start point of a critical path and a second data state of an end point of the critical path from before an adaptive test;
disabling a functional clock signal to the critical path and enabling an adaptive test clock signal to the critical path during the adaptive test;
providing an adaptive check data pattern to the start point of the critical path during the adaptive test;
generating a timing violation signal indicative of at least one of a setup violation, a hold violation, or a voltage violation at the end point of the critical path in response to the adaptive check data pattern during the adaptive test;
restoring the first data state to the start point of the critical path and the second data state of the end point of the critical path after the adaptive test; and
disabling the adaptive test clock signal to the critical path and enabling the functional clock signal to the critical path after the adaptive test.

10. The method of claim 9, wherein preserving the first data state and restoring the first data state uses a first loopback channel coupled to one of a first multiplexer or latch circuit coupled to the start point of the critical path and wherein preserving the second data state and restoring the second data state uses a second loopback channel coupled to one of a second multiplexer or latch circuit coupled to the end point of the critical path; or
wherein during the adaptive test the method further comprises providing state data from a non-critical path that is coupled to the critical path through combinatorial logic.

11. The method of claim 9, further comprising:
providing the adaptive check data pattern to a data pin of the end point of the critical path through a delay chain circuit during the adaptive test for setup margin detection; and
selectively coupling different pluralities of buffers in the delay chain circuit to the data pin of the end point of the critical path during the adaptive test for at least one of setup margin detection in terms of buffer count, voltage margin detection in terms of buffer count, or clock speed margin detection in terms of buffer count.

12. The method of claim 9, further comprising:
providing the adaptive test clock signal to a clock pin of the end point of the critical path through a delay chain circuit during the adaptive test for hold-margin detection; and
selectively coupling different pluralities of buffers in the delay chain circuit to the clock pin of the end point of the critical path during the adaptive test for at least one of hold-margin detection in terms of buffer count or voltage margin detection in terms of buffer count.

13. The method of claim 9, further comprising providing an indication of the timing violation signal to an adaptive voltage scaling circuit; or
further comprising performing at least one of setup margin detection and hold-margin detection in terms of voltage step count based on the timing violation signal; or
further comprising performing setup margin detection in terms of clock signal step count based on the timing violation signal.

14. The method of claim 9, the method further comprising:
disabling the functional clock signal to a non-critical path during the adaptive test; and
enabling the functional clock signal to the non-critical path before and after the adaptive test.

15. A controller configured for monitoring performance of an integrated circuit, the controller comprising:
a processing system; and
an adaptive check and control logic comprising a first adaptive check logic circuit and a second adaptive check logic circuit that are coupled to the processing system, wherein processing system is configured to:
send an adaptive test enable signal to the first adaptive check logic circuit comprising at least one of a multiplexer or latch coupled to a start point of a critical path in the integrated circuit to preserve a first data state of the start point of the critical path and to the second adaptive check logic circuit comprising at least one of a multiplexer or latch coupled to an end point of the critical path in the integrated circuit to preserve a second data state of the end point of the critical path from before an adaptive test;
send an adaptive check clock signal to disable a functional clock signal to the critical path and enable an adaptive test clock signal to the critical path during the adaptive test;
send an adaptive check data signal to provide an adaptive check pattern to the start point of the critical path during the adaptive test;
send a timing event capture signal to capture a timing violation signal indicative of at least one of a setup violation, a hold violation, or a voltage violation at the end point of the critical path in response to the adaptive check pattern during the adaptive test;
send an adaptive check reload signal to the first adaptive check logic circuit to reload the first data state to the start point of the critical path after the adaptive test and to the second adaptive check logic circuit to reload the second data state to the end point of the critical path after the adaptive test; and
send the adaptive check clock signal to enable the functional clock signal to the critical path after the adaptive test.
